Europäisches Patentamt

(19) European Patent Office     (11) Veröffentlichungsnummer: **0 152 002**

Office européen des brevets                                **B1**

⑫                      **EUROPÄISCHE  PATENTSCHRIFT**

(45) Veröffentlichungstag der Patentschrift:     (51) Int. Cl.⁴: **H 02 J  3/06,** G 05 F  1/30,
     **17.11.88**                                          **H 03 H  7/20**

(21) Anmeldenummer: **85100830.0**

(22) Anmeldetag: **28.01.85**

(54) **Phasenschieber.**

(30) Priorität: **10.02.84  CH 647/84**

(43) Veröffentlichungstag der Anmeldung:
     **21.08.85 Patentblatt 85/34**

(45) Bekanntmachung des Hinweises auf die Patenterteilung:
     **17.11.88 Patentblatt 88/46**

(84) Benannte Vertragsstaaten:
     **CH DE FR GB LI SE**

(56) Entgegenhaltungen:
     **EP - A - 0 053 413**
     **DE - C - 590 553**
     **FR - A - 643 880**
     **GB - A - 1 207 251**
     **US - A - 3 601 686**

**IEEE TRANSACTIONS ON POWER APPARATUS AND
SYSTEMS, Band PAS-100, Nr. 5, Mai 1981, Seiten
2650-2655, New York, US; R.M. MATHUR u.a.: "A
thyristor controlled static phase-shifter for AC power
transmission"
PROCEEDINGS OF THE INSTITUTION OF ELECTRICAL
ENGINEERS, Band 126, Nr. 6, Juni 1979, Seiten 493-498,
Stevenage, GB; J. ARRILLAGA u.a.:
"Thyristor-controlled quadrature boosting"**

(73) Patentinhaber: **BBC Brown Boveri AG, Haselstrasse,
     CH-5401 Baden (CH)**

(72) Erfinder: **Ari, Niyazi, Dr., Landstrasse 154,
     CH-5415 Nussbaumen (CH)**
     Erfinder: **Linhofer, Gerhard, Allemendstrasse 33A,
     CH-5400 Baden (CH)**

**Beschreibung**

Bei der Erfindung wird ausgegangen von einem Phasenschieber nach dem Oberbegriff des Patentanspruchs 1.

Phasenschieber werden in vermaschten Stromversorgungsnetzen zur Verbesserung der Energieübertragung und zur Vermeidung schädlicher Rückwirkungen auf das Stromversorgungsnetz und die Generatoren beim Zusammenschalten von Hochspannungsleitungen verwendet.

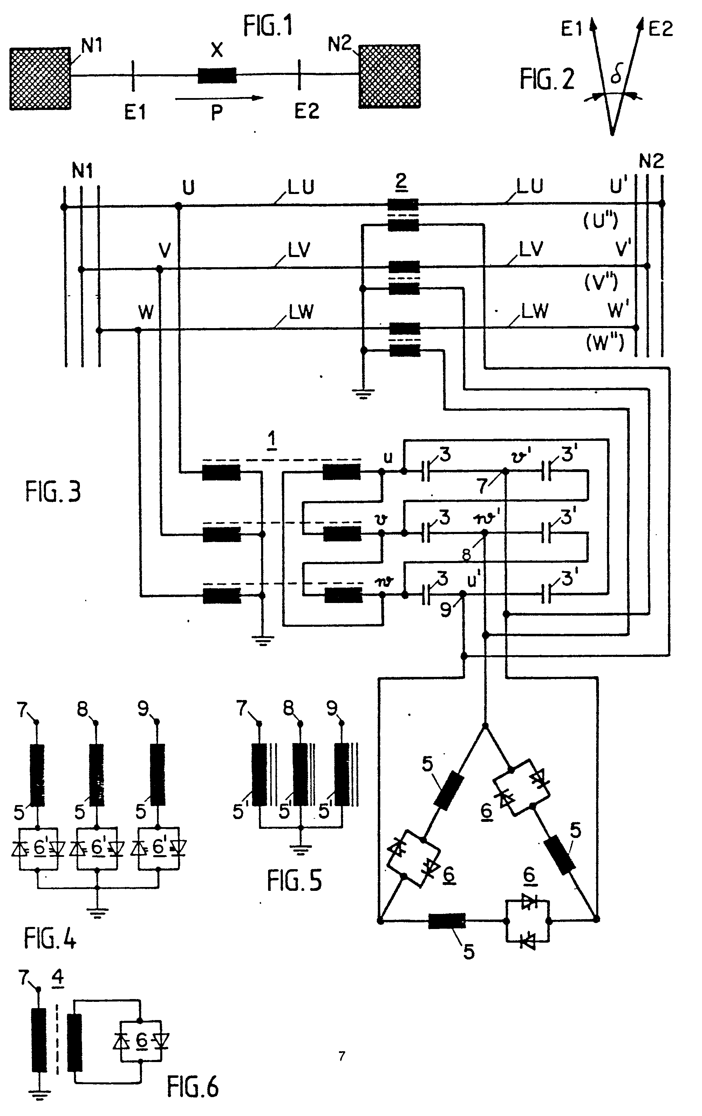

Der Energiefluß zwischen zwei durch Leitungen verbundenen Netzpunkten ist durch den Phasenwinkel zwischen den Spannungen an diesen Punkten und durch die Impedanz zwischen den beiden Punkten bestimmt. Fig. 1 und 2 veranschaulichen diese Zusammenhänge. In Fig. 1 sind mit N1 und N2 die zwei Teilnetze für Drehstrom zur elektrischen Energieübertragung und -verteilung bezeichnet, die durch eine Leitung miteinander verbunden sind. E1 und E2 bezeichnet die Spannungen an den Sammelschienen von N1 und N2, X die Impedanz zwischen E1 und E2 bzw. die Längsimpedanz der Leitung, falls nur eine Leitung vorhanden ist, und P die übertragene elektrische Leistung, für die gilt:

$$P \approx E1 \cdot E2 \cdot \sin \delta / X,$$

worin δ den Phasenwinkel zwischen den Spannungen E1 und E2 bedeutet, vgl. Fig. 2.

Bei einer Drehstromübertragung sind zwei der Hauptprobleme die Stabilität der Übertragung und die Lastflußregelung im Netz.

Übertragungsstabilität: Mit zunehmendem Phasenwinkel zwischen zwei Teilnetzen verringert sich das die Maschinen der beiden Teilnetze in Tritt haltende Synchronisierungsmoment. Dies bedeutet, daß bereits kleine kurzzeitige Netzstörungen zum Außertrittfallen der durch die Übertragungsleitungen verbundenen Kraftwerke führen können. Bei den heute verwendeten Maschinenregelungen und den mit modernen Leistungsschaltern erreichbaren kurzen Fehlerklärungszeiten liegt in der Regel die Grenze der dynamischen Stabilität bei einem Phasenwinkel von etwa 30° und die der transienten Stabilität noch darunter. Mit Phasenwinkel ist hier der Winkel zwischen den Spannungszeigern am Anfang und am Ende der Leitung gemeint. Der Winkel zwischen den Spannungszeigern der internen Maschinenspannungen ist entsprechend größer. Bei großen Übertragungsentfernungen kann oft nicht einmal die natürliche Leistung der Leitung ausgenutzt werden, ohne Überschreitung der Stabilitätsgrenze. Übliche Maßnahmen zur Verbesserung des Übertragungsverhaltens von Leitungen mit gleichzeitig stabilitätsstützender Wirkung sind der Einsatz von Seriekondensatoren und von regelbarer Shuntkompensation.

Lastflußregelung: Der Lastfluß innerhalb eines elektrischen Netzes stellt sich weitgehend selbsttätig ein. Herrscht in einem Teilnetz ein Wirkleistungsmanko, hat dies unmittelbar ein Nacheilen des Phasenwinkels gegenüber den anderen Teilnetzen zur Folge. Dies wiederum bewirkt eine sofortige Zunahme des Wirkleistungsflusses in Richtung des Teilnetzes mit dem Wirkleistungsmanko.

Probleme ergeben sich nun in Ringnetzen, in stark vermaschten Netzen sowie, wenn Teilnetze über mehrere Leitungen unterschiedlicher Spannungsebenen miteinander verbunden sind. Da sich der Lastfluß über eine Leitung in Abhängigkeit von Phasenwinkel und Leitungslängsimpedanz selbsttätig einstellt, kann es geschehen, daß die einzelnen Leitungen stark unterschiedlich belastet werden. Meist entstehen dadurch unnötig hohe Übertragungsverluste, und in Extremfällen können Leitungen sogar überlastet werden. Für Abhilfe sorgen hier Einrichtungen, wie z. B. Querregler, welche eine Zusatzspannung mit einer Phasenverschiebung von 90° oder auch Schrägregler, welche eine Zusatzspannung mit einer Phasenverschiebung von 30° oder 60° einführen.

Die Erfindung nimmt mit dem Oberbegriff auf einen Stand der Technik von Phasenschiebern Bezug, wie er in IEEE Transactions on Power Apparatus and Systems, Vol. PAS-100, No. 5, Mai 1981, S 2650–2655 beschrieben ist. Dort ist im Zwischenkreis zwischen einem von der Netzspannung gespeisten Erregertransformator, der eine Zwischenkreisspannung erzeugt, und einem eine Zusatzspannung erzeugenden Zusatztransformator, dessen Sekundärwicklung in Reihe mit der zu beeinflussenden Stromleitung des Stromnetzes geschaltet ist, eine Drosselspule vorgesehen, die entweder parallel oder in Reihe zur Primärwicklung des Zusatztransformators geschaltet ist. Im ersten Fall liegt ein Wechselstromschalter mit antiparallel geschalteten Thyristoren in Reihe und im zweiten Fall parallel zur Primärwicklung des Zusatztransformators. Damit lassen sich zu den Netzphasenspannungen während vorgebbarer Zeitintervalle um 90° phasenverschobene Spannungskomponenten mit vorgegebener Amplitude, entsprechend der Induktivität der Drosselspule, addieren. Aus dieser Veröffentlichung ist es auch bekannt, eine Zusatzspannung aus dem Spannungsabfall einer thyristorgesteuerten Drosselspule zu erzeugen.

Die der Primärwicklung des Zusatztransformators zugeführte Wechselspannungsamplitude ist hierbei höchstens gleich der Amplitude der an der Sekundärwicklung des Erregertransformators auftretenden Ausgangsspannung. Um eine Zusatzspannung bestimmter Amplitude zu erzeugen, muß der Erregertransformator relativ leistungsstark ausgelegt sein.

Die Erfindung, wie sie in den Patentansprüchen gekennzeichnet ist, löst die Aufgabe, einen Phasenschieber anzugeben, dessen die Zwischenkreisspannung erzeugender Transformator leistungsschwächer ausgelegt sein kann.

Ein Vorteil der Erfindung besteht in einer Verbilligung des Phasenschiebers. Um eine bestimmte Zusatzspannung zu erzeugen, wird ein vergleichsweise geringerer Stellbereich des diese Zwischenkreisspannung erzeugenden Transformators benötigt. Dies wird durch die Verwendung eines Resonanzkreises im Zwischenkreis zwischen den beiden Transformatoren erreicht. Mit einer geringen Verstimmung des Resonanzkreises läßt sich eine große Spannungsänderung bewirken. Da die Zusatzspannung teilweise durch einen Resonanzeffekt erzeugt wird. kann die Typenleistung des Erregertransformators kleiner gewählt werden als die Boosterleistung bzw. die Leistung des Zusatztransformators, was bei anderen Querreglerkonzepten nicht möglich ist.

Gemäß einer vorteilhaften Ausgestaltung der Erfindung wird mehr Flexibilität bezüglich der Phase und der Amplitude der zu erzeugenden Zusatzspannung erreicht. Die Phase läßt sich auf einfache Weise durch die Größe der in Reihe geschalteten Kondensatoren je Wechselstromphase vorgeben und die Amplitude durch eine Änderung der Induktivität von induktiven Widerständen. die je an einen Abgriff zwischen den Kondensatoren angeschlossen sind. Durch die Kondensatoren im Resonanzkreis wird gleichzeitig eine Verkürzung der Leitungsinduktivität bewirkt und eine bessere statische Stabilität des Stromversorgungsnetzes gegen Störungen. die darin auftreten, wie z. B. Erdschluß.

Besonders vorteilhaft ist es, als induktiven Widerstand eine Drossel mit ferromagnetischem Kern zu verwenden, der mit zunehmender Stromstärke durch die Drossel in Sättigung übergeht und damit eine Widerstandsänderung bewirkt. Dabei kann gegebenenfalls ein Wechselstromschalter in Reihe mit der Drossel eingespart werden.

Ein weiterer Vorteil besteht darin, daß vom Erregertransformator keine Regulierwicklung mit Anzapfungen verlangt wird. Da viele Netzkupplungstransformatoren mit einer Tertiär- oder Ausgleichswicklung ausgestattet sind, kann der Zwischenkreis des Querreglers direkt an diese Ausgleichswicklung angeschlossen werden, wodurch sich in vielen Fällen die Anschaffung eines separaten Erregertransformators erübrigt.

Der erfindungsgemäße Phasenschieber stellt eine vorteilhafte Kombination eines schnell regelbaren statischen Quer- bzw. Schrägreglers mit einer regelbaren Serienkompensation dar.

Die Erfindung wird nachstehend anhand von Ausführungsbeispielen erläutert. Es zeigen:

Fig. 1 und 2 zum Stand der Technik zählende Prinzipdarstellungen eines Stromversorgungsnetzes und des darin auftretenden Phasenwinkels. zur Erläuterung des Energieflusses in vermaschten Stromversorgungsnetzen.

Fig. 3 ein Ausführungsbeispiel der Erfindung.

Fig. 4 bis 6 unterschiedliche variable Blindwiderstände. die anstelle der Blindwiderstände in dem Ausführungsbeispiel gemäß Fig. 3 verwendet werden kann.

Fig. 7 ein Zeigerdiagramm der vektoriellen Addition der Zusatzspannungen zu den Eingangsspannungen und

Fig. 8 ein Zeigerdiagramm von Zwischenkreis- und Abgriffsspannungen, die am Zwischenkreis bei einem Ausführungsbeispiel gemäß Fig. 3 auftreten.

In Fig. 3 ist mit 1 ein Erregertransformator bezeichnet. dessen 3 Primärwicklungen in Sternschaltung mit 3 Phasenleitern LU, LV, LW verbunden sind, an denen Eingangsspannungen U. V, W des Drehstrom führenden Teilnetzes N1 anliegen. Der Sternpunkt ist geerdet. An sekundärseitigen Klemmen von 3 Sekundärwicklungen des Erregertransformators 1 in Dreieckschaltung sind Zwischenkreisspannungen u. v. w abgreifbar.

Zwischen diese sekundärseitigen Klemmen benachbarter Drehstromphasen sind jeweils zwei in Reihe geschaltete Kondensatorbänke oder Kondensatoren 3 und 3' geschaltet. An Abgriffen 7 bis 9 in der elektrischen Verbindung zwischen den beiden Kondensatoren 3 und 3' sind jeweils Abgriffsspannungen v'. w', u' abgreifbar. Jeder dieser drei Abgriffe 7 bis 9 ist mit jedem anderen Abgriff über eine Reihenschaltung aus einer Luftdrossel 5 und einem Wechselstromschalter 6 aus antiparallel geschalteten Thyristoren verbunden.

In Sammelschienenlängsrichtung bzw. in Reihe mit den phasenmäßig zu beeinflussenden Phasenleitern LU, LV, LW ist je eine Sekundärwicklung eines Booster- oder Zusatztransformators 2 geschaltet. deren 3 Primärwicklungen einerseits geerdet und andererseits mit den drei Abgriffen 7 bis 9 zwischen den in Reihe geschalteten Kondensatoren 3 und 3' verbunden sind. Dabei ist die Primärwicklung des Zusatztransformators 2, welche die Netzeingangsspannung U beeinflußt, mit dem Abgriff 9 verbunden. an dem die Abgriffspannung u' und an dessen Kondensator 3 die Zwischenkreisspannung w anliegt. Die beiden anderen Primärwicklungen von 2, welche die Netzeingangsspannungen V und W beeinflussen, sind entsprechend mit den Abgriffen 7 und 8 verbunden.

An den Sekundärwicklungen des Zusatztransformators 2 liegen einerseits die Netzspannungen U. V. W an und andererseits die geregelten Ausgangsspannungen U', V', W' im Leerlauf bzw. U", V", W" bei nicht dargestellter ohmscher und induktiver Belastung. Über diesen Sekundärwicklungen fallen die Zusatzspannungen U'–U bzw. U"–U usw. an.

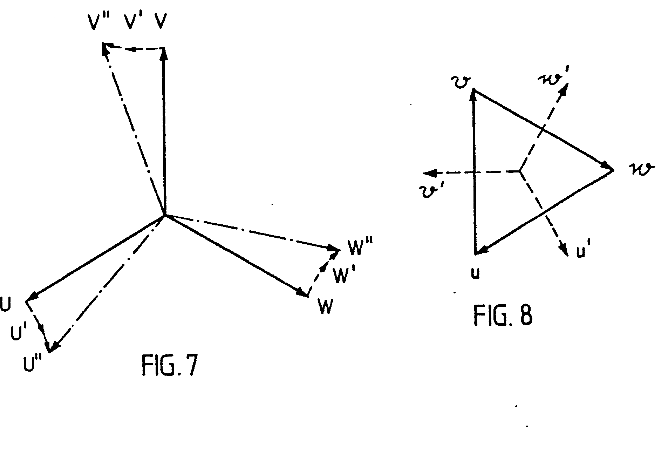

Fig. 7 zeigt das zugehörige Vektorspannungsdiagramm, wobei die strichpunktierten Linien die resultierenden Ausgangsspannungen kennzeichnen.

Fig. 8 zeigt die Spannungsverhältnisse am sekundärseitigen Ausgang des Erregertransformators 1 mit den Zwischenkreisspannungen u, v, w und an den Abgriffen 7 bis 9 mit den Abgriffsspannungen u', v', w'.

Mit Hilfe der Kondensatoren 3 und 3' kann die Phasenlage der Zusatzspannung beeinflußt werden und durch eine Veränderung der Induktivität der induktiven Widerstände bzw. Drosseln 5 die Amplitude der Zusatzspannung, unter Ausnutzung des Resonanzeffekts zwischen Induktivität und Kapazität. Die Induktivitätsänderung erfolgt hierbei durch die steuerbaren antiparallel geschalteten Thyristorventile 6. Die Größe der Kapazität der Kondensatoren und der Induktivität der induktiven Widerstände wird in Abhängigkeit von der erforderlichen Zwischenkreisspannung, der benötigten Phasenverschiebung und der Durchgangsleistung bestimmt. Üblich sind Kapazitäten im Bereich von 1 µF... 300 µF und Induktivitäten von 50 mH und mehr.

Anstelle der in Fig. 3 gezeigten Dreieckschaltung der Luftdrosseln 5 kann auch eine Sternschaltung gemäß Fig. 4 verwendet werden, wobei jede Luftdrossel 5 einerseits mit einem Abgriff 7, bzw. 8, bzw. 9 und andererseits über einen Wechselstromschalter 6' mit jeder anderen Luftdrossel 5 verbunden und geerdet ist. Als Wechselstromschalter sind hier ausschaltbare antiparallel geschaltete Thyristoren vorgesehen, die es erlauben, die Luftdrosseln 5 mehrmals innerhalb einer Halbschwingung des Wechselstromes ein- und auszuschalten. Damit kann der Oberschwingungsgehalt des Wechselstromes verringert werden.

Anstelle der Luftdrosseln 5 gemäß Fig. 4 können, wie aus Fig. 5 ersichtlich, auch Drosseln 5′ mit ferromagnetischem Kern, vorzugsweise mit einem Eisenkern, verwendet werden. Die Kerne sind ab einer Sättigungsstromstärke gesättigt, so daß sich die Induktivität der Drosseln ab dieser Sättigungsstromstärke mit zunehmender Stromstärke verringert. Bei dieser Schaltung entfallen die Wechselstromschalter 6′ von Fig. 4.

Anstelle der Drosseln 5′ gemäß Fig. 5 können als variable induktive Widerstände auch Transformatoren verwendet werden, deren Sekundärwicklungen jeweils an einen Wechselstromschalter aus zwei antiparallel geschalteten Thyristoren angeschlossen sind. Der Einfachheit halber ist in Fig. 6 nur ein Transformator 4 für eine Phase des Wechselstroms gezeigt. Die Primärwicklung dieses Transformators 4 ist einerseits an den Abgriff 7 und andererseits an eine Erdleitung angeschlossen. Mit dem Wechselstromschalter 6 kann der Sekundärkreis des Transformators 4 kurzgeschlossen und aufgetrennt werden. Bei offenem Sekundärkreis des Transformators 4 ist in dessen Primärkreis die relativ große Leerlaufinduktivität wirksam, bei geschlossenem Sekundärkreis nur die kleinere, sogenannte Kurzschluß- oder Streuimpedanz des Transformators. Der Wechselstromschalter 6 im Sekundärkreis des Transformators 4 bietet gegenüber einem Schaltelement in Reihe mit einem induktiven Widerstand den Vorteil, daß er nur für die heruntertransformierte und deshalb wesentlich geringere Sekundärspannung des Transformators 4 ausgelegt zu sein braucht.

Es versteht sich, daß die veränderlichen induktiven Widerstände gemäß den Fig. 5 und 6 auch in Dreieckschaltung, wie bei Fig. 3, verwendet werden können. Anstelle der ausschaltbaren Thyristorschalter 6′ gemäß Fig. 4 lassen sich auch Thyristorschalter 6 gemäß den Fig. 3 und 6 verwenden und umgekehrt, statt der Thyristorschalter 6, Thyristorschalter 6′ mit ausschaltbaren Thyristoren. Wichtig ist, daß die Induktivität in dem Resonanzkreis in Abhängigkeit von der gewünschten Zusatzspannung geändert werden kann.

Statt einzelner Kondensatoren 3 und 3′ können auch mehrere parallelgeschaltete Kondensatoren verwendet werden.

Anstelle des in Fig. 3 dargestellten Resonanzkreises zwischen Erregertransformator 1 und Zusatztransformator 2 kann auch ein anderer Wechselstrom-Resonanzkreis verwendet werden. So können anstelle der Kondensatoren 3 und 3′ veränderliche induktive Widerstände und anstelle der veränderlichen induktiven Widerstände 5 in Stern oder Dreieck geschaltete Kondensatoren verwendet werden.

Anstelle eines Erregertransformators in Stern-Dreieckschaltung kann selbstverständlich auch ein Erregertransformator in Dreieck-Sternschaltung verwendet werden. Vorteilhaft, aber nicht notwendig ist eine Phasenverschiebung der Zwischenkreisspannung u, v, w bezüglich der Netzeingangsspannung U, V, W um 90°.

**Patentansprüche**

1. Phasenschieber, insbesondere für ein mehrphasiges Stromversorgungsnetz (N1, N2),

a) mit mindestens einem ersten Transformator (1), der eingangsseitig je Phase des Wechselstromes von einer Netzeingangsspannung (U, V, W) gespeist ist und der je Phase mindestens eine Ausgangswicklung aufweist, an der im Betriebszustand eine Zwischenkreisspannung (u, v, w) abgreifbar ist,

b) mit mindestens einem Zusatztransformator (2), der für jede Phase der Wechselspannung (U, V, W) mindestens eine Primär- und Sekundärwicklung aufweist, wobei die Primärwicklungen in Abhängigkeit von diesen Zwischenkreisspannungen mit einstellbaren Spannungen gespeist sind und die Sekundärwicklungen mit bezüglich der Phase zu beeinflussenden Phasenleitern (LU, LV, LW) in Reihe geschaltet sind, dadurch gekennzeichnet,

c) daß die Ausgangswicklungen zur Erzeugung der Zwischenkreisspannungen (u, v, w) des ersten Transformators (1) über mindestens einen regelbaren Resonanzkreis (3, 3′, 4, 5, 6, 6′) mit den Primärwicklungen des Zusatztransformators (2) in Wirkverbindung stehen.

2. Phasenschieber nach Anspruch 1, dadurch gekennzeichnet,

a) daß der regelbare Resonanzkreis für jede Wechselstromphase mindestens einen ersten Kondensator (3) in Reihenschaltung mit mindestens einem zweiten Kondensator (3′) aufweist, wobei der Ausgang jedes ersten Kondensators (3) mit dem Eingang jedes zweiten Kondensators (3′) in Wirkverbindung steht und einen Abgriff (7 bis 9) aufweist, an dem eine Abgriffspannung (v′, w′, u′) zur Speisung der Primärwicklung des Zusatztransformators (2) abgreifbar ist,

b) daß der Eingang des ersten Kondensators (3) mit einer Ausgangswicklung des ersten Transformators (1) in Wirkverbindung steht,

c) daß der Ausgang jedes zweiten Kondensators (3′) mit einem Eingang des ersten Kondensators (3) einer zyklisch benachbarten Wechselstromphase in Wirkverbindung steht und

d) daß jeder Abgriff (7 bis 9) über mindestens einen regelbaren induktiven Widerstand (5, 5′, 4) mit jedem anderen Abgriff in Wirkverbindung steht.

3. Phasenschieber nach Anspruch 2, dadurch gekennzeichnet,

a) daß die regelbaren induktiven Widerstände (5, 5′, 4) in Stern- oder

b) in Dreieckschaltung miteinander verbunden sind.

4. Phasenschieber nach Anspruch 3, dadurch gekennzeichnet, daß mindestens ein regelbarer induktiver Widerstand mindestens eine Luftdrossel (5) in Reihe mit einem Wechselstromschalter (6, 6′) aufweist.

5. Phasenschieber nach Anspruch 3 oder 4, dadurch gekennzeichnet,

a) daß mindestens ein regelbarer induktiver Widerstand mindestens die Impendanz eines Transformators (4) ist.

b) in dessen Sekundärkreis ein Wechselstromschalter (6) angeordnet ist.

6. Phasenschieber nach einem der Ansprüche 3 bis 5, dadurch gekennzeichnet, daß mindestens ein regelbarer induktiver Widerstand mindestens eine Drossel (5') mit einem ferromagnetischen Kern aufweist.

7. Phasenschieber nach Anspruch 4 oder 5, dadurch gekennzeichnet,

a) daß der Wechselstromschalter (6, 6') antiparallel geschaltete steuerbare elektrische Ventile aufweist, insbesondere,

b) daß diese Ventile ausschaltbare Thyristoren sind.

8. Phasenschieber nach einem der vorhergehenden Ansprüche, dadurch gekennzeichnet, daß der erste Transformator ein Erregertransformator (1) ist, der eingangsseitig eine Stern- und ausgangsseitig eine Dreiecksschaltung aufweist.

9. Phasenschieber nach einem der Ansprüche 1 bis 7, dadurch gekennzeichnet, daß der erste Transformator ein Netzkupplungstransformator mit einer Tertiär- oder Ausgleichswicklung ist, welche als Ausgangswicklung zur Erzeugung der Zwischenkreisspannung (u, v, w) verwendet wird.

**Claims**

1. Phase shifter, particularly for a multi-phase power supply system (N1, N2), comprising

a) at least one first transformer (1), which at its input is fed by a system input voltage (U, V, W) for each phase of the alternating current and which has for each phase at least one output winding at which, in the operating condition, an intermediate-circuit voltage (u, v, w) can be tapped off,

b) at least one auxiliary transformer (2) which for each phase of the alternating voltage (U, V, W) has at least one primary and secondary winding, the primary windings being fed as a function of these intermediate-circuit voltages having voltages which can be regulated and the secondary windings being series-connected to phase conductors (LU, LV, LW) which are to be influenced with respect to phas, characterised in that

c) the output windings for generating the intermediate-circuit voltages (u, v, w) of the first transformer (1) are operatively connected via at least one controllable resonant circuit (3, 3', 4, 5, 6, 6') to the primary windings of the auxiliary transformer (2).

2. Phase shifter according to claim 1, characterised in that

a) the controllable resonant circuit for each alternating-current phase is provided with at least one first capacitor (3) which is series-connected to at least one second capacitor (3'), the output of each first capacitor (3) being operatively connected to the input of each second capacitor (3') and being provided with a tap (7 to 9) at which a tap voltage (v', w', u') can be tapped off for feeding the primary winding of the auxiliary transformer (2),

b) the input of the first capacitor (3) is operatively connected to an output winding of the first transformer (1),

c) the output of each second capacitor (3') is operatively connected to an input of the first capacitor (3) of a cyclically adjacent alternating-current phase and that

d) each tap (7–9) is operatively connected via at least one controllable inductive resistance (5, 5', 4) to each other tap.

3. Phase shifter according to claim 2, characterised in that

a) the controllable inductive resistances (5, 5', 4) are connected to each other in star or

b) in delta connection.

4. Phase shifter according to claim 3, characterised in that at least one controllable inductive resistance is provided with at least one air choke (5) in series with one alternating-current switch (6, 6').

5. Phase shifter according to claim 3 or 4, characterised in that

a) at least one controllable inductive resistance is at least the impedance of a transformer (4),

b) in the secondary circuit of which an alternating-current switch (6) is arranged.

6. Phase shifter according to one of claims 3 to 5, characterised in that at least one controllable inductive resistance is provided with at least one choke (5') having a ferromagnetic core.

7. Phase shifter according to claim 4 or 5, characterised in that

a) the alternating-current switch (6, 6') is provided with antiparallel-connected controllable electric valves and, in particular, that

b) these valves are thyristors which can be turned off.

8. Phase shifter according to one of the preceding claims, characterised in that the first transformer is an exciter transformer (1) which has star-connection at its input and a delta-connection at its output.

9. Phase shifter according to one of claims 1 to 7, characterised in that the first transformer is a system coupling transformer having a tertiary or compensation winding which is used as output winding for generating the intermediate-circuit voltage (u, v, w)

**Revendications**

1. Déphaseur, en particulier pour un réseau d'alimentation électrique polyphasé (N1, N2),

a) comportant au moins un premier transformateur (1) qui, du côté d'entrée, pour chaque phase du courant alternatif, est alimenté par une tension d'entrée de réseau (U, V, W) et qui, pour chaque phase, comporte au moins un enroulement de sortie sur lequel, à l'état opérationnel, une tension de circuit intermédiaire (u, v, w) peut être prise;

b) comportant au moins un transformateur survolteur (2) qui, pour chaque phase de la tension alternative (U, V, W), comporte au moins un enroulement primaire et un enroulement secondaire, les enroulements primaires étant alimentés au moyen de tensions réglables en fonction de ces tensions de circuit intermédiaire et les enroulements secondaires étant connectés en série aux lignes de phase (LU, LV, LW) à influencer quant à leur phase; caractérisé en ce que

c) les enroulements de sortie du premier transformateur (1) destinés à produire les tensions de circuit intermédiaire (u. v. w) sont en liaison active par l'intermédiaire d'au moins un circuit résonnant réglable (3, 3'. 4, 5. 6, 6') avec les enroulements primaires du transformateur survolteur (2).

2. Déphaseur suivant la revendication 1. caractérisé en ce que

a) le circuit résonnant réglable pour chaque phase de courant alternatif comporte au moins un premier condensateur (3) en série avec au moins un second condensateur (3'), la sortie de chaque premier condensateur (3) étant en liaison active avec l'entrée de chaque second condensateur (3') et présentant une prise (7 à 9) sur laquelle une tension de prise (v', w', u') peut être prélevée pour alimenter l'enroulement primaire du transformateur survolteur (2);

b) l'entrée du premier condensateur (3) est en liaison active avec un enroulement de sortie du premier transformateur (1);

c) la sortie de chaque second condensateur (3') est en liaison active avec une entrée du premier condensateur (3) d'une phase de courant alternatif cycliquement voisine, et

d) chaque prise (7 à 9) est en liaison active par l'intermédiaire d'au moins une résistance inductive réglable (5, 5', 4) avec chaque autre prise.

3. Déphaseur suivant la revendication 2, caractérisé en ce que

a) les résistances inductives réglables (5, 5'. 4) sont connectées l'une à l'autre en étoile, ou

b) en delta.

4. Déphaseur suivant la revendication 3, caractérisé en ce qu'au moins une résistance inductive réglable comporte au moins une bobine de choc à air (5) en série avec un commutateur à courant alternatif (6, 6').

5. Déphaseur suivant la revendication 3 ou 4. caractérisé en ce que

a) au moins une résistance inductive réglable est au moins l'impédance d'un transformateur (4),

b) dans le circuit secondaire duquel est connecté un commutateur à courant alternatif.

6. Déphaseur suivant l'une quelconque des revendications 2 à 5, caractérisé en ce qu'au moins une résistance inductive réglable comporte au moins une bobine de choc (5') comportant un noyau ferromagnétique.

7. Déphaseur suivant la revendication 4 ou 5, caractérisé en ce que

a) le commutateur à courant alternatif (6, 6') comporte des soupapes électriques pilotables connectées de manière antiparallèle. et

b) ces soupapes sont, en particulier. des thyristors déclenchables.

8. Déphaseur suivant l'une quelconque des revendications précédentes. caractérisé en se que le premier transformateur est un transformateur d'excitation (1) qui, du côté d'entrée, comporte un montage en étoile et du côté de sortie un montage en delta.

9. Déphaseur suivant l'une quelconque des revendications 1 à 7, caractérisé en ce que le premier transformateur est un transformateur de couplage au réseau comportant un enroulement tertiaire ou d'égalisation. qui est utilisé comme enroulement de sortie pour produire la tension de circuit intermédiaire (u, v, w).

FIG.1

FIG.2

FIG.3

FIG.4

FIG.5

FIG.6

V" V' V

U
U'
U"

W"
W'
W

FIG. 7

𝑣
𝑤'
𝑣'
𝑤
u'
u

FIG. 8